# EUROPEAN PATENT SPECIFICATION

(11) **EP 4 325 471 B1**
(45) Date of publication and mention of the grant of the patent: **01.10.2025**
(21) Application number: 22919304.0
(22) Date of filing: 03.08.2022
(51) Int. Cl.: H10H 29/49, H05K 1/02, H05K 1/11, H05K 1/18

(54) **LED LAMP PANEL STRUCTURE**
LED-LAMPENTAFELSTRUKTUR
STRUCTURE DE PANNEAU DE LAMPES À DEL

(30) Priority: 05.07.2022 CN 202210792752
(43) Date of publication of application: 21.02.2024
(73) Proprietor: Jiangxi MTC Visual Display Co., Ltd, Nanchang, Jiangxi 330000 (CN)
(72) Inventor: ZHANG, Haibo, Shenzhen, Guangdong 518000 (CN); HE, Shengbin, Shenzhen, Guangdong 518000 (CN); GU, Wei, Shenzhen, Guangdong 518000 (CN)
(74) Representative: Murgitroyd & Company
(86) International application number: PCT/CN2022/110048
(87) International publication number: WO 2024/007400

(56) References cited:
- EP-A1- 3 680 932
- CN-A- 106 201 143
- CN-A- 109 298 577
- CN-A- 111 462 643
- CN-A- 111 540 297
- CN-A- 113 012 629
- CN-U- 213 751 735
- US-A1- 2011 080 434
- US-A1- 2014 008 674
- US-A1- 2021 265 546
- US-A1- 2022 068 998

## Description

### TECHNICAL FIELD

The present disclosure relates to a field of LED display technology, and more particularly, to LED panel structures.

### BACKGROUND

An LED display screen is a flat panel display, which is an apparatus composed of small LEDs for displaying various information such as text, images, videos, and the like. The LED electronic display screen combines the application of a microelectronic technology, a computer technology, and information processing, and has the advantages of bright color, wide dynamic range, high brightness, long service life, stable and reliable operation, and the like. Led displays are widely used in commercial media, cultural performance markets, stadiums, information dissemination, news release, securities trading, and the like.

CN 106201143 A, US 2014008674 A1 and EP 3680932 A1 disclose an LED panel structure.

In the design process of an existing LED display screen, a scanning line and a data line on the PCB board may cross. Therefore, the scanning line is usually provided on the surface layer of the PCB board, and the data line is provided on the inner layer or the bottom layer of the PCB board by adding via holes to the PCB board, so that the number of via holes is equal to the number of LEDs on the PCB board. Since the number of via holes on the PCB board determines the yield of the PCB board, the more via holes, the higher the defect rate of the PCB board. Therefore, the inventors have realized that how to reduce the number of via holes on the PCB board so as to improve the yield of the PCB board, reduce the waste of materials, and reduce the manufacturing cost of the PCB board is a technical problem urgently to be solved at present.

### SUMMARY

### Technical problem

In view of the deficiencies of the prior art, the present disclosure provides an LED panel structure, which is intended to solve the technical problem of more via holes on the PCB board and high manufacturing cost in the prior art.

### Technical solution

To solve the above problems, the present invention provides an LED panel structure according to claim 1.

Preferably, in the LED panel structure, a plurality of LEDs in two adjacent rows in the first direction form a first LED row, and a data line corresponding to the LEDs in each row of the first LED row passes through the first LED row in the first direction.

More preferably, in the LED panel structure, in the first LED row, common-electrode terminals of two adjacent LEDs in each of columns crossing the data line are electrically connected to each other through the via holes, so that a plurality of scanning lines at corresponding positions in the first LED row are arranged on an inner layer of the PCB board.

More preferably, in the LED panel structure, in the first LED row, common-electrode terminals of two adjacent LEDs in each of columns crossing the data line are electrically connected to each other through the via holes, so that a plurality of the scanning lines at corresponding positions in the first LED row are arranged on a bottom layer of the PCB board.

Preferably, in the LED panel structure, a plurality of LEDs in two adjacent rows in the first direction form a second LED row, and common-electrode terminals of the LEDs in each of the plurality of columns in the second LED row are electrically connected to each other on a surface layer of the PCB board.

Preferably, in the LED panel structure, the light-emitting pixels are arranged in the first direction and the second direction in the array manner.

Preferably, in the LED panel structure, the first direction is a row direction, and the second direction is a column direction.

Preferably, in the LED panel structure, each of the light-emitting pixels is the same.

Preferably, in the LED panel structure, each of the light-emitting pixels comprises a red LED, a blue LED, and a green LED.

Preferably, in the LED panel structure, the LEDs in each of the rows in the first direction are LEDs of the same light-emitting color.

Preferably, in the LED panel structure, each of the LEDs is any one of a red LED, a blue LED, and a green LED.

Preferably, in the LED panel structure, each of the LEDs is the same.

Preferably, in the LED panel structure, a common-electrode terminal of each of the LEDs is a common anode.

Preferably, in the LED panel structure, a common-electrode terminal of each of the LEDs is a common cathode.

Preferably, in the LED panel structure, the scanning line is a column scanning line, and the data line is a row data line.

Preferably, in the LED panel structure, common-electrode terminals of LED lamp beads of each of a plurality of groups of two adjacent columns are adjacent in the first direction.

Preferably, in the LED panel structure, non-common-electrode terminals of LEDs of each of a plurality of groups of two adjacent columns are adjacent in the first direction.

Preferably, in the LED panel structure, the LEDs are encapsulated on the PCB board in a COB manner or an SMD manner.

### Beneficial effect

In the LED panel structure provided in the present invention, the plurality of LEDs arranged in an array manner in the first direction and the second direction are provided on a PCB board, the plurality of adjacent LEDs are sequentially arranged in the second direction to form the plurality of light-emitting pixels, the common-electrode terminals of the plurality of LEDs in the rows in the second direction are electrically connected to each other through the via holes to form one scanning line in the second direction, and the non-common-electrode terminals of LEDs in each row in the first direction are electrically connected to each other on the surface layer of the PCB board to form one data line in the first direction, so that the number of via holes on the PCB board is less than the number of LEDs, thereby improving the yield of the PCB board, reducing waste of materials, and reducing the manufacturing cost of the PCB board.

### BRIEF DESCRIPTION OF THE DRAWINGS

In order to more clearly explain the technical solutions in the embodiments of the present invention, the following will briefly introduce the drawings required in the description of the embodiments. Obviously, the drawings in the following description are only some embodiments of the present invention. For those skilled in the art, without paying any creative work, other drawings can be obtained based on these drawings.
FIG. 1 is a schematic diagram of an LED panel structure in the prior art;
FIG. 2 is another schematic diagram of an LED panel structure in the prior art;
FIG. 3 is a schematic diagram of an LED panel structure according to an embodiment of the present disclosure;
FIG. 4 is a schematic diagram of an LED panel structure according to another embodiment of the present disclosure;
FIG. 5 is a schematic diagram of an LED panel structure according to another embodiment of the present disclosure;
FIG. 6 is a schematic diagram of an LED panel structure according to another embodiment of the present disclosure;
FIG. 7 is a schematic diagram of an LED panel structure according to another embodiment of the present disclosure; and
FIG. 8 is a schematic diagram of an LED panel structure according to another embodiment of the present disclosure.

### DETAILED DESCRIPTION

Technical solutions in embodiments of the present invention will be clearly and completely described below in conjunction with drawings in the embodiments of the present invention. Obviously, the described embodiments are only a part of embodiments of the present invention, rather than all the embodiments. Based on the embodiments in the present invention, all other embodiments obtained by those skilled in the art without creative work fall within the protection scope of the present invention as defined by the claims.

In the description of the present disclosure, it should be understood that orientations or position relationships indicated by the terms "center", "lateral", "upper", "lower", "left", "right", "vertical", "horizontal", "top", "bottom", "inside", "outside", "column," "row," and the like, are based on orientations or position relationships illustrated in the drawings. The terms are used to facilitate and simplify the description of the present disclosure, rather than indicate or imply that the devices or elements referred to herein are required to have specific orientations or be constructed or operate in the specific orientations. Accordingly, the terms should not be construed as limiting the present disclosure.

In the present disclosure, the word "some embodiments" is used to mean "serving as an example, illustration, or explanation". Any embodiment described as exemplary in the present disclosure is not necessarily construed as being more preferable or advantageous than other embodiments. In order to enable any person skilled in the art to implement and use the present disclosure, the following description is given. In the following description, the details are listed for the purpose of explanation. It should be understood that those of ordinary skill in the art can realize that the present disclosure can also be implemented without using these specific details. In other instances, well-known structures and processes will not be elaborated to avoid unnecessary details to obscure the description of the present disclosure. Therefore, the present disclosure is not intended to be limited to the illustrated embodiments, but is consistent with the widest scope that conforms to the principles disclosed in the present disclosure.

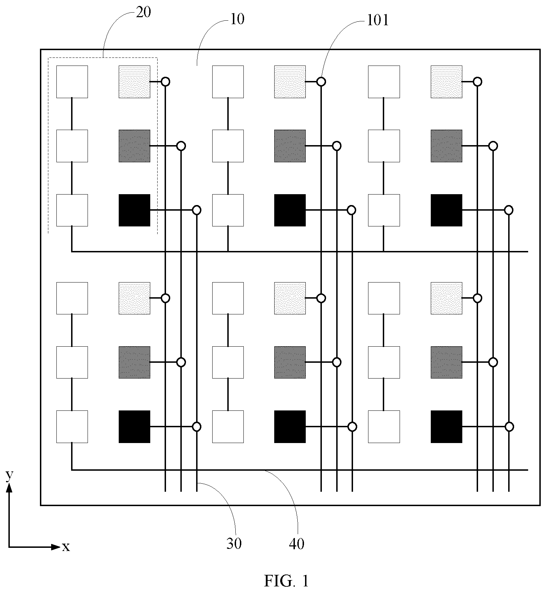

It should be noted that a first direction and a second direction mentioned in the embodiments of the present disclosure are perpendicular to each other, and the first direction may be a column direction or a row direction. Similarly, the second direction corresponds to the row direction or the column direction, and the first direction and the second direction may be interchanged in actual application. When the first direction is an x direction indicated in FIGS. 1 to 7, that is, each of a first LED row and a second LED row is a column of LEDs, the second direction is a y direction indicated in FIGS. 1 to 7, that is, the third LED row is a row of LEDs, the x direction in FIGS. 1 to 7 is a row direction, and the y direction is a column direction.

Referring to FIG. 1, there is shown a schematic diagram of an LED panel structure in the prior art. As shown in FIG. 1, a plurality of light-emitting pixels 20 with the same structure are arranged on a PCB board 10 in an array manner., and each of the light-emitting pixels 20 includes three LEDs of different light-emitting colors, such as, a red LED, a blue LED, and a green LED, so that both the LEDs and the light-emitting pixels 20 are arranged on the PCB board 10 in an array manner. Common-electrode terminals of all the LEDs in each row of the light-emitting pixels 20 are electrically connected to each other on the surface layer of the PCB board 10 to form one row scanning line, and non-common-electrode terminals of the LEDs of the same light-emitting color in each column of the light-emitting pixels 20 are electrically connected to each other on the inner or bottom layer of the PCB board 10 through via holes 101 on the PCB board 10 to form one column data line. Here, the strobe chip performs progressive scanning of the pixels on the PCB board 10 through scanning lines 30, and the driver chip applies different currents through data lines 40 to obtain different colors in various light-emitting pixels 20, thereby obtaining a complete image on the PCB board 10.

As can be seen from FIG. 1, the number of via holes 101 in the PCB board 10 is determined by the number of LEDs, and three via holes 101 are required for each light-emitting pixel 20 to enable the data lines 40 to be led to the inner or bottom layer of the PCB board 10.

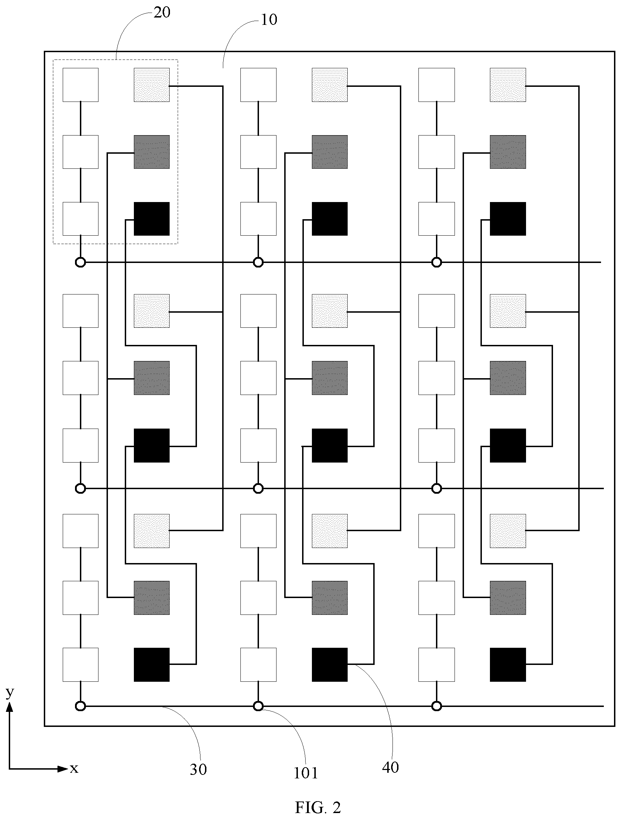

Referring to FIG. 2, FIG. 2 is a schematic diagram of another LED panel structure in the prior art. As shown in FIG. 2, a plurality of light-emitting pixels 20 of the same structure are arranged in an array on a PCB board 10, and each of the light-emitting pixels 20 includes three LEDs of different light-emitting colors, such as, a red LED, a blue LED, and a green LED, so that both the LEDs and the light-emitting pixels 20 are arranged in an array on the PCB board 10. Common-electrode terminals of all the LEDs in each row of light-emitting pixels 20 are electrically connected to each other on the inner or bottom layer of the PCB board 10 through via holes 101 in the PCB board 10 to form one row scanning line, and non-common-electrode terminals of the LEDs of the same light-emitting color in each column of light-emitting pixels 20 are electrically connected to each other on a surface layer of the PCB board 10 to form one column data line 40.

As can be seen from FIG. 2, in order to avoid the problem of intersection of the scanning line 30 and the data line 40 and to reduce the number of via holes 101 on the PCB board 10, in each column of light-emitting pixels 20, two data lines 40 need to pass between the positive and negative electrodes of one or more LEDs. Although only one via hole 101 is required for each light-emitting pixel 20 in FIG. 2, due to the constraints of the wiring rules of the PCB board 10, the data line 40 passing between the positive and negative electrodes of the LEDs will inevitably cause the size of the LEDs to be increased, thereby causing a sharp increase in cost. As an example of the conventional COB chip 0408 (4 mil×8 mil), the distance between the positive and negative electrodes of the COB chip is only 75µm, and generally, the pad spacing on the PCB board 10 should be designed to be smaller than the pad spacing on the COB chip to prevent the occurrence of misalignment, so the value of the pad spacing on the PCB board 10 is generally 70µm. In accordance with the process level of the PCB board 10, the line width and the line spacing of the general wirings are both 100µm. If two data lines 40 both pass between the positive and negative electrodes of the COB chip, the distance between the positive and negative electrodes of the COB chip is at least 500µm. In this case, the COB chip must be much larger than the design size of the original 75µm of the diode, which will make the diode very large and cause the manufacturing cost to increase sharply.

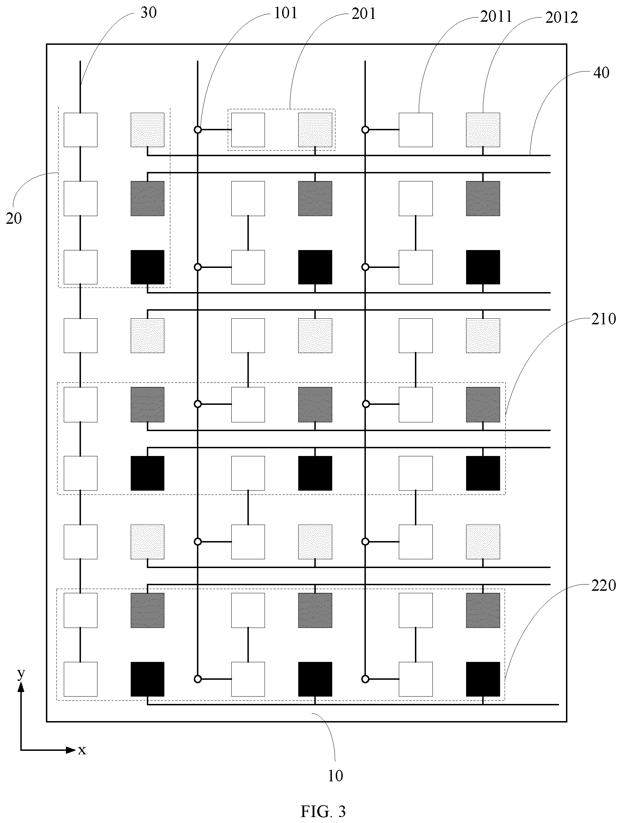

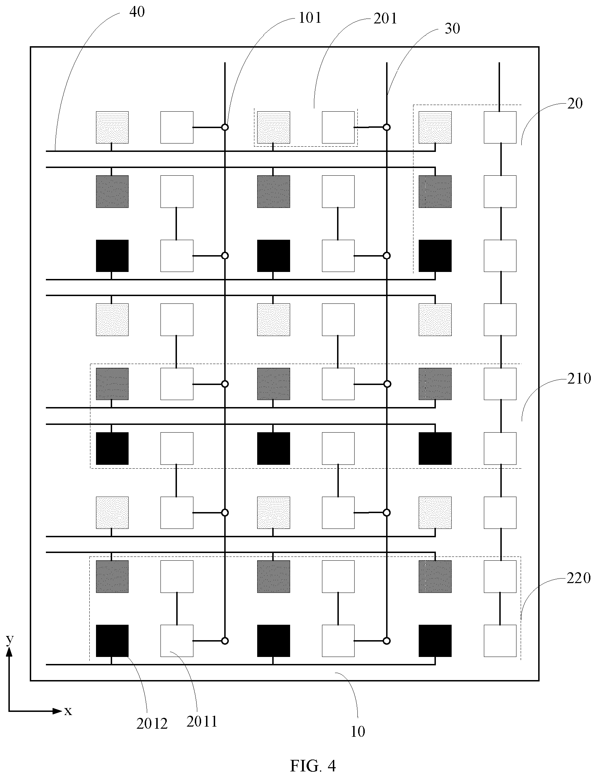

Referring to FIGS. 3 and 4, FIG. 3 is a schematic diagram of an LED panel structure according to an embodiment of the present disclosure, and FIG. 4 is a schematic diagram of an LED panel structure according to another embodiment of the present disclosure. As shown in FIGS. 3 and 4, an LED panel structure includes a PCB board 10 and a plurality of LEDs 201.

The PCB board 10 is provided with a plurality of via holes 101.

The plurality of LEDs 201 are arranged on the PCB board 10, the LEDs 201 are arranged in an array manner along a first direction and a second direction, and a plurality of adjacent LEDs 201 are sequentially arranged in the second direction to form a plurality of light-emitting pixels 20.

Common-electrode terminals 2011 of the LEDs 201 in a plurality of rows in the second direction are electrically connected to each other through the via holes 101 to form one scan line 30 in the second direction;

Non-common-electrode terminals 2012 of the LEDs 201 in each row in the first direction are electrically connected to each other on the surface layer of the PCB board 10 to form one data line 40 in the first direction.

According to the LED panel structure provided in the embodiment of the present disclosure, the plurality of LEDs 201 arrayed in the first direction and the second direction are provided on the PCB board 10, the plurality of adjacent LEDs 201 are arranged in the second direction sequentially to form a plurality of light-emitting pixels 20, the common-electrode terminals 2011 of the LEDs 201 in the plurality of rows in the second direction are electrically connected through the via holes 101 to form one scanning line 30 in the second direction, and the non-common-electrode terminals 2012 of LEDs 201 in each row in the first direction are electrically connected to each other on the surface layer of the PCB board 10 to form one data line 40 in the first direction, so that the number of via holes 101 in the PCB board 10 is smaller than the number of LEDs 201, thereby improving the yield of the PCB board 10, reducing waste of materials, and reducing the manufacturing cost of the PCB board 10.

Specifically, when all the LEDs 201 are arranged in the manner shown in FIG. 3, that is, the common-electrode terminals 2011 of the LEDs 201 are located on the left sides of the LEDs 201, and the non-common-electrode terminals 2012 are located on the right sides of the LEDs 201, the non-common-electrode terminals 2012 of the LEDs 201 in each row in the first direction are electrically connected to each other on the surface layer of the PCB board 10 to form one data line 40 in the first direction. The data line 40 may be directly routed between the two LEDs 201 without passing through the gap region between the cathode and the anode of any LED 201 on the PCB board 10. The common-electrode terminals 2011 of all the LEDs 201 in a first row in the second direction are electrically connected to each other on the surface layer of the PCB board 10 without increasing the size of the LEDs 201, so as to form one scanning line 30 in the second direction. No via hole 101 is required for each LED 201 in the first row, it can be realized that the common-electrode terminals 2011 of all the LEDs 201 in the first row are electrically connected to each other on the surface layer of the PCB board 10, thereby reducing the number of via holes 101 in the PCB board 10.

Similarly, when all the LEDs 201 are arranged in the manner shown in FIG. 4, that is, the common-electrode terminals 2011 of the LEDs 201 are located on the right sides of the LEDs 201, and the non-common-electrode terminals 2012 are located on the left sides of the LEDs 201, the non-common-electrode terminals 2012 of the LEDs 201 in each row in the first direction are electrically connected to each other on the surface layer of the PCB board 10, so as to form one data line 40 in the first direction. The data line 40 can be directly routed between the two LEDs 201 without passing through the gap region between the cathode and the anode of any LED 201 on the PCB board 10. Similarly, without increasing the size of the LEDs 201, the common-electrode terminals 2011 of all the LEDs 201 in the last row in the second direction are electrically connected to each other on the surface layer of the PCB board 10, so as to form one scanning line 30 in the second direction. Likewise, no via hole 101 is required for each LED 201 in the last row, it can be realized that the common-electrode terminals 2011 of all the LEDs 201 in the last row are electrically connected to each other on the surface layer of the PCB board 10, thereby reducing the number of via holes 101 in the PCB board 10.

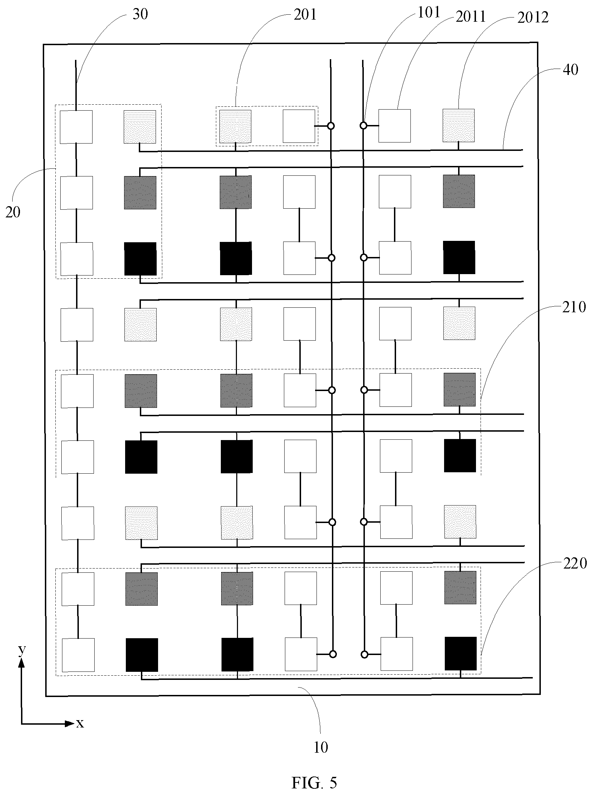

In the present disclosure, each LED 201 on the PCB board 10 may be an LED with the same size or may be an LED with a different size. The arrangement of the LEDs 201 on the PCB board 10 may be the same, or may be different. When the arrangement of the LEDs 201 on the PCB board 10 is different, there may be several groups of two adjacent rows of LEDs 201 of which the common-electrode terminals 2011 or the non-common-electrode terminals 2012 are adjacent to each other. As shown in FIG. 5, the non-common-electrode terminals 2012 of the LEDs 201 in the first row in the second direction may be adjacent to the non-common-electrode terminals 2012 of the LEDs 201 in the second row, the common-electrode terminals 2011 of the LEDs 201 in the second row may be adjacent to the common-electrode terminals 2011 of the LEDs 201 in the third row, and it is also possible to realize that the common-electrode terminals 2011 of the LEDs 201 in the plurality of rows in the second direction are electrically connected to each other through the via holes 101 to form one scanning line 30 in the second direction, and the non-common-electrode terminals 2012 of the LEDs 201 in each row in the first direction are electrically connected to each other on the surface layer of the PCB board 10 to form one data line 40 in the first direction, so that the number of the via holes 101 in the PCB board 10 is smaller than the number of the LEDs 201, thereby improving the yield of the PCB board 10, reducing waste of materials, and reducing the manufacturing cost of the PCB board 10.

Meanwhile, the common-electrode terminal 2011 of the LED 201 may be a common cathode or a common anode. The gap region between the two rows of LEDs 201 in the first direction can be used for one data line 40 or two data lines 40.

In addition, after the non-common-electrode terminals 2012 of the LEDs 201 in each row in the first direction are electrically connected to each other on the surface layer of the PCB board 10 to form one data line 40 in the first direction, LEDs 201 in each row needs to be LEDs 201 of the same light-emitting color, so that the scanning line 30 in the LED display screen is changed from the row scanning line to the column scanning line, and the data line 40 is changed from the column data line to the row data line.

In some embodiments, a plurality LEDs 201 of two adjacent rows in the first direction form a first LED row 210, the data line 40 corresponding to each row of the LEDs 201 in the first LED row 210 passes through the first LED row 210 along the first direction. Specifically, the data line 40 corresponding to each row of LEDs 201 in the first LED row 210 passes through the gap region between the two rows of LEDs 201 in the first LED row 210 along the first direction. At this time, common-electrode terminals 2011 of LEDs 201 in one row of the first LED row 210 can be electrically connected to common-electrode terminals 2011 of LEDs 201 in a row above the first LED row 210 on the surface layer of the PCB board 10, and common-electrode terminals 2011 of LEDs 201 in another row of the first LED row 210 and the common-electrode terminals 2011 of LEDs 201 in a row below the first LED row 210 can form the scanning line 30 in the second direction through the via hole 101 in the PCB board 10, thereby further reducing the number of the via holes 101 in the PCB board 10 and improving the yield of the PCB board 10.

In some embodiments, in the first LED row 210, the common-electrode terminals 2011 of a plurality of the LEDs 201 in any one row are electrically connected to each other through the via holes 101 to enable a plurality of scanning lines 30 at corresponding positions in the first LED row 210 to be disposed on the inner or bottom layer of the PCB board 10. Specifically, in the first LED row 210, there is no need to provide a via hole 101 for each of all the LEDs 201 on the PCB board 10. Common-electrode terminals 2011 of a part of the LEDs 201 in the first LED row 210 may be connected with common-electrode terminals 2011 of lower LEDs 201 below them respectively through routing on the surface layer of the PCB board 10, and common-electrode terminals 2011 of remaining LEDs 201 in the first LED row 210 may be connected to the routing on the inner layer or bottom layer of the PCB board 10 directly through the via holes 101 in the PCB board 10.

It may be appreciated that each of all the first LED rows 210 in the first direction is formed by two adjacent rows of LEDs 201. One first LED row 210 may be present on the PCB board 10, or a plurality of groups of the first LED rows 210 may be present on the PCB board 10. The number of the groups of the first LED rows 210 may be specifically selected depending on the actual application, which is not specifically limited in the present disclosure.

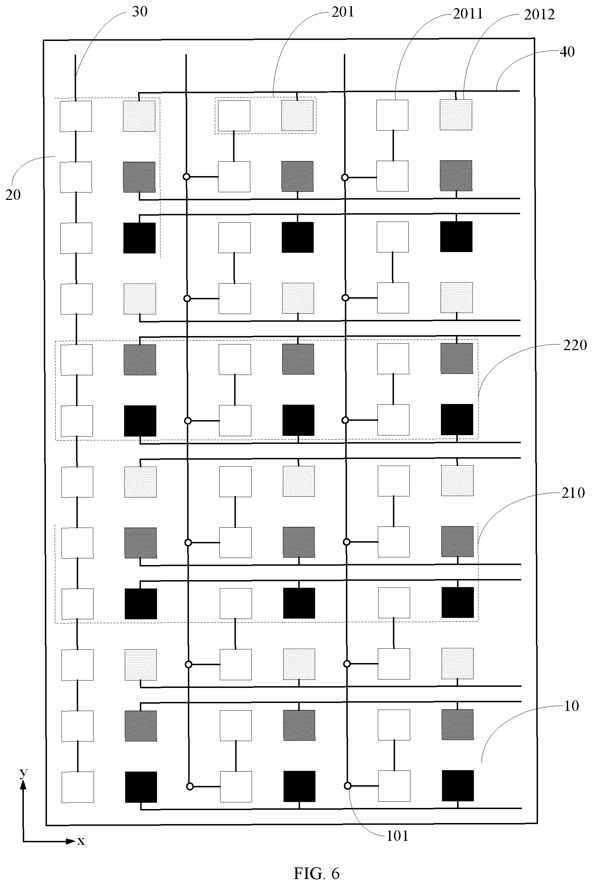

It may also be appreciated that any two adjacent rows of LEDs 201 in the first direction may form the first LED row 210, LEDs 201 in a first row and LEDs 201 in a second row may form the first LED row 210 as shown in FIG. 3 and FIG. 4, the LEDs 201 in the second row and LEDs 201 in a third row may form the first LED row 210 as shown in FIG. 6, and the first LED rows 210 may be formed in such a manner specifically selected according to actual application, which is not specifically limited in the present disclosure.

Meanwhile, in order to minimize the number of via holes 101 in the PCB board 10, if there is an LED 201 above the first LED row 210, the common-electrode terminal 2011 of the LED 201 in the first LED row 210 adjacent to the upper LED 201 may share one via hole 101 with a common-electrode terminal 2011 of the upper LED 201, that is, two common-electrode terminals 2011 are connected by routing on the surface layer of the PCB board 10, as long as one of the two common-electrode terminals 2011 is electrically connected to the common-electrode terminal 2011 of the other row on the inner or bottom layer of the PCB board 10 through the via hole 101. If there is an LED 201 below the first LED row 210, the common-electrode terminal 2011 of the LED 201 in the first LED row 210 adjacent to the lower LED 201 may share one via hole 101 with a common-electrode terminal 2011 of the lower LED 201, that is, two common-electrode terminals 2011 are connected by routing on the surface layer of the PCB board 10, as long as one of the two common-electrode terminals 2011 is electrically connected to the common-electrode terminal 2011 of the other row on the inner or bottom layer of the PCB board 10 through the via hole 101.

In some embodiments, in the LED panel structure, a plurality of the LEDs 201 of two adjacent rows in the first direction form a second LED row 220, the common-electrode terminals 2011 of the adjacent LEDs 201 in the two rows in the second LED row 220 are electrically connected to each other on the surface layer of the PCB board 10.

It may be appreciated that the second LED row 220 in the first direction may likewise be formed by the LEDs 201 in two adjacent rows, and the gap region between the adjacent LEDs 201 in the two rows may be used to route between the common-electrode terminals 2011 of the adjacent LEDs 201 in the two rows on the surface layer of the PCB board 10, so that the two adjacent LEDs 201 share one via hole 101 in the PCB board 10, thereby reducing the number of via holes 101 in the PCB board 10, increasing the yield of the PCB board 10, and reducing the manufacturing cost of the PCB board 10.

It may also be appreciated that each of all the second LED rows 220 in the first direction is formed by two adjacent rows of LEDs 201. A group of the second LED rows 220 may be present on the PCB board 10, or a plurality of groups of the second LED rows 220 may be present on the PCB board 10. Any two adjacent rows of LEDs 201 may form the second LED row 220, LEDs 201 in a first row and LEDs 201 in a second row may form the second LED row 220 as show in FIG. 6, and the LEDs 201 of the second row and LEDs 201 in a third row may form the second LED row 220 as shown in FIGS. 3 and 4. The number of the groups of the second LED rows 220, and the forming manner of the second LED rows 220 may be specifically selected according to the actual application, which is not specifically limited in the present disclosure.

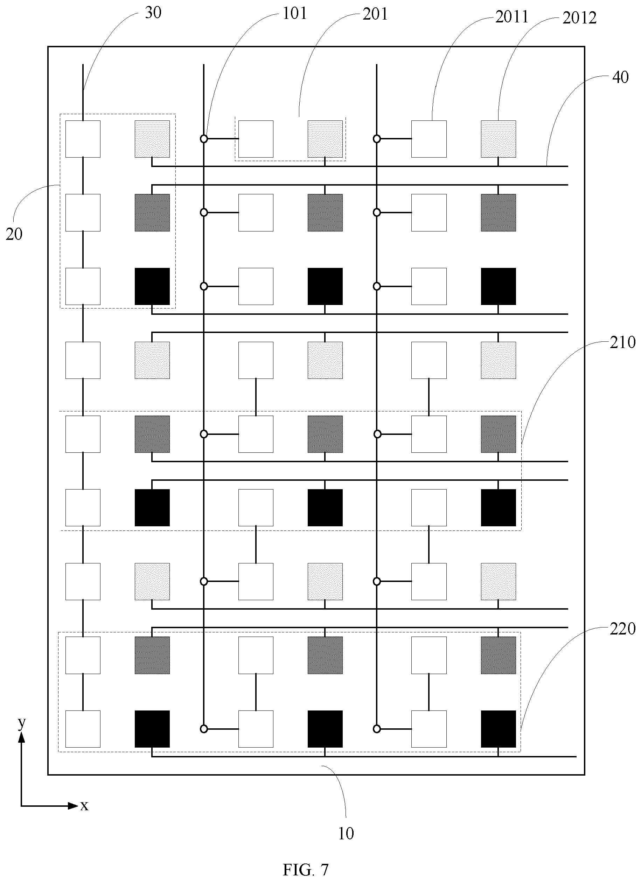

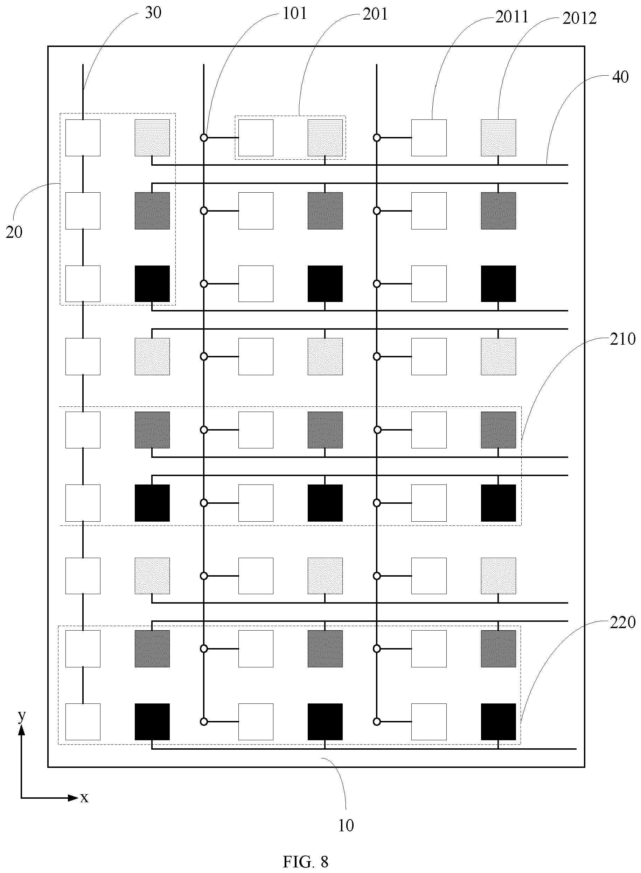

In some embodiments, as shown in FIG. 7, the common-electrode terminals 2011 of a part of the LEDs 201 in each row in the second direction may pass through the via holes 101 in the PCB board 10 to form the scanning lines 30 in the second direction. As shown in FIG. 8, except for the leftmost LEDs 201 in each row of LEDs 201, the common-electrode terminals 2011 of the remaining LEDs 201 in each row may pass through the via holes 101 in the PCB board 10 to form the scanning lines 30 in the second direction. Compared with the arrangement of the LEDs 201 in the prior art, the arrangement of the LEDs 201 shown in FIGS. 7 and 8 may reduce the number of via holes 101 in the PCB board 10.

In some embodiments, the light-emitting pixels 20 are arrayed in the first direction and the second direction. The LED 201 may be any one of a red LED, a blue LED, and a green LED. In this embodiment, each light-emitting pixel 20 may be the same, and each light-emitting pixel 20 may be formed by the red LED, the blue LED, and the green LED. The red LED, the blue LED, and the green LED may be vertically arranged from top to bottom in a second direction in sequence, so that the left and right viewing angles of the LED display screen are symmetrical, and the left and right viewing angles of the LED display screen formed into a finished product are maximized.

It may be appreciated that the arrangement of the LEDs 201 in FIGS. 3 to 8 can be rotated by 90 degree in practical applications, that is, the column scanning lines formed in FIGS. 3 to 7 become row scanning lines, the row data lines formed in FIGS. 3 to 7 become column data lines, and the LEDs 201 in each of the light-emitting pixels 20 are arranged horizontally.

It may also be appreciated that the LEDs 201 in the LED panel structure provided in the embodiments of the present disclosure may be packaged on the PCB board 10 in a COB (Chip On Board) manner, or may be packaged on the PCB board 10 in a SMD (Surface Mounted Devices) manner, which may be selected according to the specific situation in the actual application, and is not specifically limited in the present disclosure.

In the specific implementation, each of the above units or structures may be implemented as a separate object, or may be implemented in any combination as the same object or several objects. For a specific implementation of each of the above units or structures, reference may be made to the foregoing embodiments, and details are not described herein.

The LED panel structure according to the present invention have been described in detail. The principles and embodiments of the present invention have been described with reference to specific embodiments, and the description of the above embodiments is merely intended to aid in the understanding of the method of the present invention. At the same time, changes may be made by those skilled in the art to both the specific implementations and the scope of application in accordance with the teachings of the present invention. In view of the foregoing, the content of the present specification should not be construed as limiting the scope of the present invention which is defined by the claims.

## Claims

1. An LED panel structure, comprising:
a PCB board (10) provided with a plurality of via holes (101); and
a plurality of LEDs (201) arranged on a surface layer of the PCB board (10), wherein the LEDs (201) are arranged in a plurality of rows extending in a first direction (x) and a plurality of columns extending a second direction (y) to form an array of a plurality of light-emitting pixels (20);
wherein common-electrode terminals (2011) of the LEDs (201) in at least one of the plurality of columns extending in the second direction (y) are electrically connected to each other through the via holes (101) to form at least one scanning line (30) extending in the second direction (y) on a different layer of the PCB board (10) than the surface layer;
wherein common-electrode terminals (2011) of each of the LEDs (201) in the first column or in the last column of the plurality of columns extending in the second direction (y) are electrically connected to each other on the surface layer of the PCB board (10) to form one scanning line (30) extending in the second direction (y) on the surface layer of the PCB board (10), and
wherein non-common-electrode terminals (2012) of each of the LEDs (201) in each of the plurality of rows extending in the first direction (x) are electrically connected to each other on the surface layer of the PCB board (10) to form a plurality of data lines (40) extending in the first direction (x) on the surface layer of the PCB board (10).

2. The LED panel structure according to claim 1, **characterized in that** a plurality of LEDs (201) in two adjacent rows in the first direction (x) form a first LED row (210), and a data line (40) corresponding to the LEDs (201) in each of the two adjacent rows in the first LED row (210) passes through the first LED row (210) in the first direction (x).

3. The LED panel structure according to claim 2, **characterized in that** in the first LED row (210), common-electrode terminals (2011) of two adjacent LEDs (201) in each of columns crossing the data line (40) are electrically connected to each other through the via holes (101), so that a plurality of scanning lines (30) at corresponding positions in the first LED row (210) are arranged on an inner layer or a bottom layer of the PCB board (10).

4. The LED panel structure according to claim 1, **characterized in that** a plurality of LEDs (201) in two adjacent rows in the first direction (x) form a second LED row (220), and common-electrode terminals (2011) of the LEDs (201) in each of the plurality of column in the second LED row (220) are electrically connected to each other on a surface layer of the PCB board (10).

5. The LED panel structure according to claim 1, **characterized in that** the light-emitting pixels (20) are arranged in the first direction (x) and the second direction (y) in the array manner.

6. The LED panel structure according to claim 1, **characterized in that** each of the light-emitting pixels (20) comprises a red LED, a blue LED, and a green LED.

7. The LED panel structure according to claim 1, **characterized in that** the LEDs (201) in each of the rows in the first direction (x) are LEDs (201) of the same light-emitting color.

8. The LED panel structure according to claim 1, **characterized in that** each of the LEDs (201) is any one of a red LED, a blue LED, and a green LED.

9. The LED panel structure according to claim 1, **characterized in that** each of the LEDs (201) is the same.

10. The LED panel structure according to claim 1, **characterized in that** a common-electrode terminal (2011) of each of the LEDs (201) is a common anode.

11. The LED panel structure according to claim 1, **characterized in that** a common-electrode terminal (2011) of each of the LEDs (201) is a common cathode.

12. The LED panel structure according to claim 1, **characterized in that**, common-electrode terminals (2011) of LED lamp beads (201) of each of a plurality of groups of two adjacent columns are adjacent in the first direction (x).

13. The LED panel structure according to claim 1, **characterized in that** non-common-electrode terminals (2012) of LEDs (201) of each of a plurality of groups of two adjacent columns are adjacent in the first direction (x).

## Patentansprüche

1. Struktur eines LED-Panels, die Folgendes umfasst:
eine Leiterplatte (10), die mit einer Vielzahl von Durchgangslöchern (101) versehen ist; und
eine Vielzahl von LEDs (201), die auf einer Oberflächenschicht der Leiterplatte (10) angeordnet sind, wobei die LEDs (201) in einer Vielzahl von Reihen, die sich in einer ersten Richtung (x) erstrecken, und einer Vielzahl von Spalten, die sich in einer zweiten Richtung (y) erstrecken, angeordnet sind, um ein Array aus einer Vielzahl von lichtemittierenden Pixeln (20) zu bilden;
wobei gemeinsame Elektrodenanschlüsse (2011) der LEDs (201) in mindestens einer der Vielzahl von Spalten, die sich in der zweiten Richtung (y) erstrecken, elektrisch miteinander über die Durchgangslöcher (101)verbunden sind, um mindestens eine Abtastleitung (30) zu bilden, die sich in der zweiten Richtung (y) auf einer anderen Schicht der Leiterplatte (10) als der Oberflächenschicht erstreckt;
wobei Anschlüsse mit einer gemeinsamen Elektrode (2011) jeder der LEDs (201) in der ersten Spalte oder in der letzten Spalte der Vielzahl von Spalten, die sich in der zweiten Richtung (y) erstrecken, elektrisch miteinander auf der Oberflächenschicht der Leiterplatte (10) verbunden sind, um eine Abtastlinie (30) zu bilden, die sich in der zweiten Richtung (y) auf der Oberflächenschicht der Leiterplatte (10) erstreckt, und
wobei Anschlüsse nicht mit einer gemeinsamen Elektrode (2012) jeder der LEDs (201) in jeder der Vielzahl von Reihen, die sich in der ersten Richtung (x) erstrecken, elektrisch miteinander auf der Oberflächenschicht der Leiterplatte (10) verbunden sind, um eine Vielzahl von Datenleitungen (40) zu bilden, die sich in der ersten Richtung (x) auf der Oberflächenschicht der Leiterplatte (10) erstrecken.

2. Struktur eines LED-Panels nach Anspruch 1, **dadurch gekennzeichnet, dass** eine Vielzahl von LEDs (201) in zwei in der ersten Richtung (x) benachbarten Reihen eine erste LED-Reihe (210) bildet, und eine Datenleitung (40), die den LEDs (201) in jeder der beiden benachbarten Reihen in der ersten LED-Reihe (210) entspricht, durch die erste LED-Reihe (210) in der ersten Richtung (x) verläuft.

3. Struktur eines LED-Panels nach Anspruch 2, **dadurch gekennzeichnet, dass** in der ersten LED-Reihe (210) Anschlüsse mit einer gemeinsamen Elektrode (2011) von zwei benachbarten LEDs (201) in jeder der Spalten, die die Datenleitung (40) kreuzen, durch die Durchgangslöcher (101) elektrisch miteinander verbunden sind, so dass eine Vielzahl von Abtastlinien (30) an entsprechenden Positionen in der ersten LED-Reihe (210) auf einer inneren Schicht oder einer unteren Schicht der Leiterplatte (10) angeordnet sind.

4. Struktur eines LED-Panels nach Anspruch 1, **dadurch gekennzeichnet, dass** eine Vielzahl von LEDs (201) in zwei benachbarten Reihen in der ersten Richtung (x) eine zweite LED-Reihe (220) bildet, und dass Anschlüsse mit einer gemeinsamen Elektrode (2011) von den LEDs (201) in jeder von der Vielzahl von Spalten in der zweiten LED-Reihe (220) elektrisch miteinander auf einer Oberflächenschicht der Leiterplatte (10) verbunden sind.

5. Struktur eines LED-Panels nach Anspruch 1, **dadurch gekennzeichnet, dass** die lichtemittierenden Pixel (20) in der ersten Richtung (x) und der zweiten Richtung (y) in der Art eines Arrays angeordnet sind.

6. Struktur eines LED-Panels nach Anspruch 1, **dadurch gekennzeichnet, dass** jedes der lichtemittierenden Pixel (20) eine rote LED, eine blaue LED und eine grüne LED umfasst.

7. Struktur eines LED-Panels nach Anspruch 1, **dadurch gekennzeichnet, dass** die LEDs (201) in jeder der Reihen in der ersten Richtung (x) LEDs (201) mit der gleichen lichtemittierenden Farbe sind.

8. Struktur eines LED-Panels nach Anspruch 1, **dadurch gekennzeichnet, dass** jede der LEDs (201) eine rote, blaue oder grüne LED ist.

9. Struktur eines LED-Panels nach Anspruch 1, **dadurch gekennzeichnet, dass** jede der LEDs (201) gleich ist.

10. Struktur eines LED-Panels nach Anspruch 1, **dadurch gekennzeichnet, dass** ein Anschluss mit einer gemeinsamen Elektrode (2011) jeder der LEDs (201) eine gemeinsame Anode ist.

11. Struktur eines LED-Panels nach Anspruch 1, **dadurch gekennzeichnet, dass** ein Anschluss mit einer gemeinsamen Elektrode (2011) jeder der LEDs (201) eine gemeinsame Kathode ist.

12. Struktur eines LED-Panels nach Anspruch 1, **dadurch gekennzeichnet, dass** gemeinsame Elektrodenanschlüsse (2011) von LEDs (201) in jeder von mehreren Gruppen von zwei benachbarten Spalten in der ersten Richtung (x) benachbart sind.

13. Struktur eines LED-Panels nach Anspruch 1, **dadurch gekennzeichnet, dass** nicht-gemeinsame Elektrodenanschlüsse (2012) von LEDs (201) in jeder von mehreren Gruppen von zwei benachbarten Spalten in der ersten Richtung (x) benachbart sind.

## Revendications

1. Structure de panneau DEL, comprenant :
une carte de circuit imprimé (10) munie d'une pluralité de trous traversants (101) ; et
une pluralité de DELs (201) agencées sur une couche de surface de la carte de circuit imprimé (10), dans lequel les DELs (201) sont agencées en une pluralité de rangées se prolongeant dans une première direction (x) et une pluralité de colonnes se prolongeant dans une deuxième direction (y) pour former un réseau d'une pluralité de pixels électroluminescents (20) ;
dans lequel les bornes à électrode commune (2011) des DELs (201) dans au moins une de la pluralité de colonnes se prolongeant dans une deuxième direction (y) sont mutuellement raccordées électriquement via les trous traversants (101) pour former au moins une ligne de balayage (30) se prolongeant dans une deuxième direction (y) sur une couche de la carte de circuit imprimé (10) différente de la couche de surface ;
dans lequel les bornes à électrode commune (2011) de chacune des DELs (201) dans la première colonne ou
dans la dernière colonne de la pluralité de colonnes dans la deuxième direction (y) sont mutuellement raccordées électriquement sur la couche de surface de la carte de circuit imprimé (10) pour former une ligne de balayage (30) se prolongeant dans une deuxième direction (y) sur la couche de surface de la carte de circuit imprimé (10), et
dans lequel
les bornes à électrode non commune (2012) de chacune des DELs (201) dans chacune de la pluralité de rangées se prolongeant dans la première direction (x) sont mutuellement raccordées électriquement sur la couche de surface de la carte de circuit imprimé (10) pour former une pluralité de lignes de données (40) se prolongeant dans la première direction (x) sur la couche de surface de la carte de circuit imprimé (10).

2. Structure de panneau DEL selon la revendication 1, **caractérisé en ce qu'**une pluralité de DELs (201) sur deux rangées adjacentes dans la première direction (x) forment une première rangée de DELs (210), et une ligne de données (40) correspondant aux DELs (201) de chaque deux rangées adjacentes sur la première rangée de DELs (210) passe à travers la première rangée de DELs (210) dans la première direction (x).

3. Structure de panneau DEL selon la revendication 1, **caractérisé en ce que** dans la première rangée de DELs (210), les bornes à électrode commune (2011) de deux DELs adjacentes (201) sur chaque colonne traversant la ligne de données (40) sont mutuellement raccordées électriquement via les trous traversants (101), de sorte que la pluralité de lignes de balayage (30) sur les positions correspondantes sur la première rangée de DELs (210) sont agencées sur une couche interne ou une couche inférieure de la carte de circuit imprimé(10).

4. Structure de panneau DEL selon la revendication 1, **caractérisé en ce que** la pluralité de DELs (201) sur deux rangées adjacentes dans la première direction (x) forme une deuxième rangée de DELs (220), et les bornes à électrode commune (2011) des DELs (201) dans chacune de la pluralité de colonnes sur la deuxième rangée de DELs (220) sont mutuellement raccordées électriquement sur la couche de surface de la carte de circuit imprimé (10).

5. Structure de panneau DEL selon la revendication 1, **caractérisé en ce que** les pixels électroluminescents (20) sont agencés dans la première direction (x) et la deuxième (y) en réseau.

6. Structure de panneau DEL selon la revendication 1, **caractérisé en ce que** chacun des pixels électroluminescents (20) comprend une DEL rouge, une DEL bleue, et une DEL verte.

7. Structure de panneau DEL selon la revendication 1, **caractérisé en ce que** les DELs (201) dans chacune des rangées dans la première direction (x) sont des DELs (201) de la même couleur électroluminescente.

8. Structure de panneau DEL selon la revendication 1, **caractérisé en ce que** chacune des DELs (201) est une DEL rouge, une DEL bleue, et une DEL verte quelconque.

9. Structure de panneau DEL selon la revendication 1, **caractérisé en ce que** chacune des DELs (201) est identique.

10. Structure de panneau DEL selon la revendication 1, **caractérisé en ce qu'**une borne à électrode commune (2011) de chacune des DELs (201) est une anode commune.

11. Structure de panneau DEL selon la revendication 1, **caractérisé en ce qu'**une borne à électrode commune (2011) de chacune des DELs (201) est une cathode commune.

12. Structure de panneau DEL selon la revendication 1, **caractérisé en ce que** les bornes à électrode commune (2011) de perles de lampe à DEL (201) de chacune de la pluralité de groupes de deux colonnes adjacentes sont adjacentes dans la première direction (x).

13. Structure de panneau DEL selon la revendication 1, **caractérisé en ce que** les bornes à électrode non commune (2012) de DELs (201) de chacune de la pluralité de groupes de deux colonnes adjacentes sont adjacentes dans la première direction (x).
